# EUROPEAN PATENT APPLICATION

(11) **EP 0 567 867 A2**
(43) Date of publication of application: **03.11.1993**
(21) Application number: 93106223.6
(22) Date of filing: 16.04.1993
(51) Int. Cl.: H01L 21/285

(54) **Oxidation-resistant compound of Cu3Si and fabrication thereof**

(30) Priority: 30.04.1992 US 876669
(71) Applicant: International Business Machines Corporation, Armonk, N.Y. 10504 (US)
(72) Inventor: Aboelfotoh, Osama Mohamed, Poughkeepsie, New York 12603 (US); Krusin-Elbaum, Lia, Dobbs Ferry, New York 10522 (US)
(74) Representative: Rach, Werner, Dr.

(57) **Abstract**

A corrosion-resistant and environmentally stable ternary compound is disclosed consisting of stoichiometric copper silicide (Cu₃Si), containing chromium (Cr) in the range from about 1 to 10 atomic percent, which is corrosion-resistant and environmentally stable, and thus, among other applications, is a suitable material for use as contacts and interconnects to semiconductor devices. The Cr may be added to the Cu, by co-deposition or sequentially, at the time of the deposition of the Cu onto a clean Si substrate at low temperature. The substrate may be preheated or upon receiving the deposited layer is heated to a temperature in the range of 175 to 400°C to uniformly distribute the Cr throughout the silicide layer formed on the substrate surface. The resulting ternary compound has the Cr atoms dispersed evenly through the Cu₃Si lattice which apparently suppresses the oxidation behaviour of the compound. Other refractory transition elements, e.g., Ni, Co, Fe, and Nb, and combinations thereof, may be added to or substituted for the Cr but give less effective results. Also, the substrate may be either of Si or *Si*_{*x*} Ge _{1-*x*} alloy to achieve the improved compound.

## Description

Field of the Invention The present invention relates to metallurgy and semiconductor fabrication and more particularly to a compound of copper (Cu) and silicon (Si) that is corrosion-resistant and useful in a number of applications including environmentally stable contacts and interconnects to semiconductor devices. Prior Art Many combinations of metals and alloys are used in connection with electrical devices and applications for their facility in conducting electrical currents and related qualities. It is generally desirable that these materials have low resistivity, be substantially stable, and offer other qualities that are compatible with the conditions in their fabrication and use environments. Some examples of suitable material combinations in electrical applications and environments generally are disclosed in the following prior art.

U.S.Pat.No.3,254,255 relates to brazing alloys for use in uniting members exposed to mercury vapor in devices such as electrical mercury vapor discharge devices, ignitions and switches. The brazing alloys will not amalgamate or react with mercury and consist of by weight from 0.4 to 1.2% chromium and the balance being copper.

US Patent 1,743,768 relates to a circuit interrupting switch contact formed of a metal alloy consisting of by weight 1 or 2% silicon and the balance being copper.

U.S.Pat.No.4,843,043 relates to a method of producing interlayer conductive paths having planar top surfaces in a multilayer integrated circuit structure, comprising the steps of forming a conductive or semiconductive material as a lower layer, depositing an insulating layer on top of the lower layer, implanting ions into one or more selected regions of the insulating layer, forming at least one upper conductor over the selected regions and sintering the structure to render the selected regions conductive. Various conductive materials can be employed to provide the upper and/or lower conductive lines. Such conductor materials, include aluminum and aluminum alloys, e.g., Al-Si. Other conductor materials include copper alloys, aluminum-titanium alloys, and aluminum-copper-chromium alloys.

US Patent 2,185,958 relates to alloys and in particular to silicon-copper alloys having improved physical and chemical characteristics. As a specific example, the alloy may contain by weight 1% nickel, 3.5% silicon and 95.5% copper.

UK Patent Application GB 2,051,127 A relates to precipitation hardening copper alloys comprising by weight 0.05 to 2% each of silicon, chromium, and aluminum, and the balance being copper and impurities.

Japan Patent Application J8 7027-542 B relates to a method comprising depositing metal on a silicon layer followed by heat treatment to form metal silicide.

Japan Patent Application J7 5009-144 relates to a method of forming electrodes to semiconductor devices comprising forming electroless layers of copper-nickel-silicon alloys.

US Patent 5,130,274 assigned to the same assignee as the present application, discloses combining a low resisitivity metal with another metallic element of less than 1.0 at.% to produce an alloy, the metal being Cu and the metallic element being selected from Cr or Al. The alloy is deposited on a substrate comprising an oxygen-containing dielectric to create a self-passivating layer of Cr₂O₃ or Al₂O₃ on the Cu for adhesion to the dielectric.

It will be seen from the foregoing art that many combinations of metals and of metals with silicon have been used for various electrical device applications.

In semiconductor fabrication, such combinations of metals and alloys are used particularly as conductive paths in multilayer integrated circuit (IC) structures and involve different semiconductor compounds including various metals, such as Al, Ti, Cr and most recently silicides of Cu. As discussed in applicants' article in APPL. PHYS. LETT. Vol. 58, p. 1341, (1991) and co-pending application Ser.No.07/818,027, filed 6 January 1992 and assigned to the same assignee as the present application, copper silicide (Cu₃Si), particularly in thin film form produced at low temperatures, has been found to offer many advantages in IC fabrication. But, a major drawback of this compound is its tendency to rapid oxidation which can obviate its desirability in many applications. The usual approach in the prior art to such a situation would be to use some form of passivating layer over the Cu₃Si film. However, none of the cited prior art references or any other known prior art offers any teaching or suggestion of this or any other solution to this problem.

It is therefore an object of the present invention to produce a copper silicide (Cu₃Si) at low temperatures that is corrosion-resistant and environmentally stable so as to be suitable for use as contacts and interconnects to semiconductor devices without the need for a passivating layer.

The present invention involves the discovery of a ternary compound consisting of stoichiometric copper and semiconductor, preferably, copper silicide (Cu₃Si), containing a suitable refractory transition element, preferably chromium (Cr), in the range from about 1 to 10 atomic percent of the compound, which is corrosion-resistant and environmentally stable, and thus, among other applications, is a suitable material for use as contacts and interconnects to semiconductor devices. It has been found that the addition of at least about 1 - 5 at.% Cr to Cu₃Si inhibits oxidation and renders the Cu₃Si resistant to corrosion. The Cr may be added to the Cu at the time of the the deposition of the Cu onto a clean Si substrate when creating the silicide film. If the substrate is maintained at room temperature during deposition, the composite structure containing the deposited metallic layer is annealed by heating to a temperature in the range of 175 to 400°C for a period from about 15 minutes to an hour. Otherwise, the substrate may be heated to 100 to 400°C during deposition. In either event, a Cu₃Si layer is formed with the Cr atoms distributed throughout. The resulting ternary compound has the Cr atoms dispersed evenly through the Cu₃Si lattice which apparently suppresses the oxidation behaviour of the film. Other refractory transition elements, e.g., Ni, Co, Fe, and Nb, and combinations thereof, may be added to or substituted for the Cr, to suit certain applications, but give less effective results. Also, the semiconductor may be either of Si or *Si*_{*x*} Ge _{1-*x*} alloy.

The invention eliminates the need to use a separate passivating layer over the Cu₃Si film as would be the approach most likely to be followed in the prior art.

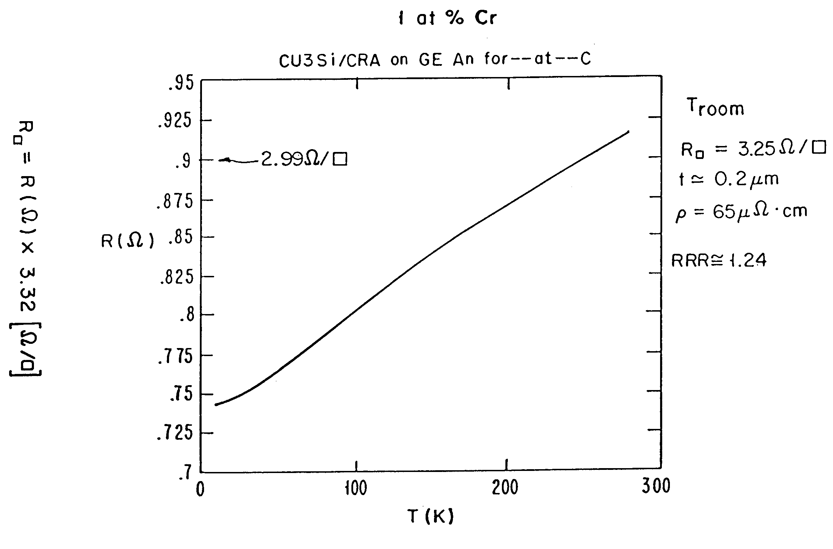

The Figure is a plot of experimentally obtained data illustrating the comparatively unchanged resistivity over a broad temperature range of the ternary compound of the present invention, using Cu, Cr, and Si as the constituents.

The present invention embodies a ternary compound, produced by a suitable system and method, consisting of stoichiometric copper and a semiconductor comprised substantially of silicon, e.g., copper silicide (Cu₃Si), containing a refractory transition element, preferably chromium (Cr), in the range from about 1 to 10 atomic percent (at%) of the compound, which can be produced at low temperature and is suitable as a material for corrosion-resistant and environmentally stable contacts and interconnects to semiconductor devices, as well as many other metallurgical applications.

More particularly, the invention may be effectively achieved in any conventional deposition apparatus wherein the constituent metals can be deposited in a distributed, comparatively thin, layer onto a semiconductor substrate or surface at low temperature, i.e., below about 600 or 700°C, to avoid significant diffusion into the substrate. The semiconductor surface must be in a clean condition for receipt of the metals thereon to permit the ready formation of a substantially defect-free silicide layer upon heat treatment. The assembling of suitable equipment and the adoption of suitable procedures for carrying out this operation will be within the purview of those of skill in the art in the light of the subsequent description herein.

Deposition of the metal constituents may be accomplished by co-deposition or sequential deposition as long as a metallic layer is created that does not substantially diffuse into and will readily react with the semiconductor surface upon which it is deposited to form the desired silicide. Thus, for example, Cr atoms may be added at the time of the deposition of the Cu by the co-deposition of Cr and Cu. Alternatively, the Cr and Cu can be deposited sequentially by first depositing a Cu layer and then a Cr layer followed by another Cu layer, or by beginning with a Cr layer and following the same sequence. In either event, a distributed thin metallic layer, of a thickness typically of anywhere from about about 50 nm to 200 nm (500Å to 2000Å), is to be formed on the receiving semiconductor surface which will consist substantially of Si.

If the substrate has been maintained at room temperature during deposition, the metallic layer and the silicon surface are then annealed by heating to a temperature in the range of about 175 to 400°C, for a period of about 15 to 60 minutes, to form a Cu-silicide layer containing uniformly dispersed Cr atoms. Alternatively, the substrate may be heated to a temperature in the range from about 100 to 400°C preparatory to deposition so that the silicide formation will be somewhat accelerated and the annealing step is eliminated. The resulting silicide layer will typically be of a thickness ranging from 200 to 300 nm (2000 to 3000Å).

The amount of Cu used in the deposition will depend on the desired thickness of the resulting silicide layer. The amount of Cr used may be in the range from about 1 to 10 at% of the resulting ternary compound and preferably about 1 at% and up to 5 at%. The resulting ternary compound has the Cr atoms distributed evenly through the Cu₃Si lattice which apparently suppresses the oxidation behaviour of the compound.

A typical resistivity vs. temperature curve for films of Cu-silicide containing uniformly dispersed Cr atoms is shown in the Figure. The resistivity has been found not to be adversely effected by exposure to air or oxygen over a period of several months. Also, the electrical properties of the compound have been found to be equivalent whether co-deposition or sequential deposition of the Cu and Cr is used. It is noted that treatment at higher temperatures, while annealing out structural defects in the compound, results in lower resistivities, and lower temperatures produce higher resistivities.

Other refractory transition elements may be added to or substituted for the Cr, e.g., Ni, Co, Fe, and Nb, and combinations thereof, to suit certain applications, but these elements typically give less effective results. Also, the semiconductor may be either of Si or *Si*_{*x*} Ge _{1-*x*} alloy.

It will therefore be seen that the disclosed constituents and processes have been found to stabilize Cu-silicide films while their electrical resistivity remains essentially unchanged as indicated by the experimentally obtained plot of resistivity versus temperature shown in the Figure. This feature obviates the prior art requirement of the use of a passivating layer over the copper silicide (Cu₃Si) film. The ternary compound produced by virtue of its stability will be found useful in many metallurgical applications as well as in VLSI technology.

## Claims

1. A method for forming an oxidation-resistant Cu-semiconductor compound, comprising the steps of:
producing an interface of a surface of Cu, containing a refractory transition element, and a surface of a semiconductor comprised substantially of Si, at a temperature at which said Cu and said refractory transition element will not substantially diffuse into said semiconductor; and
treating said interface to form an oxidation-resistant compound of Cu, refractory transition element, and said semiconductor with said refractory transition element being in the range from about 1 to 10 at.% of said compound and distributed throughout.

2. A method as in claim 1
wherein said refractory transition element is selected from the group consisting of Cr, Ni, Co, Fe, and Nb, and combinations thereof with Cr being preferred.

3. A method as in claim 2
wherein said refractory transition element comprises about 1 to 5 at.% of said compound.

4. A method according to any one of the preceding claims wherein said semiconductor comprises *Si*_{*x*} Ge _{1-*x*} alloy.

5. A method according to any one of the preceding claims wherein said treating step comprises heating said interface to uniformly disperse said refractory transition element throughout said compound, preferrably to a temperature in the range of about 100 to 400°C.

6. A method as in claim 5
wherein said treating step comprises either heating said substrate before said interface is produced, or heating said interface after it is produced.

7. A method according to any one of the preceding claims wherein said interface is produced by the co-deposition of Cu and said refractory transition element on said semiconductor surface, or by the sequential deposition of Cu and said refractory transition element on said semiconductor surface.

8. An oxidation-resistant Cu-semiconductor compound produced according to any one of claims 1 to 11.
